# EUROPÄISCHE PATENTSCHRIFT

(11) **EP 0 612 412 B1**
(45) Veröffentlichungstag und Bekanntmachung des Hinweises auf die Patenterteilung: **31.01.1996**
(21) Anmeldenummer: 92922652.0
(22) Anmeldetag: 06.11.1992
(51) Int. Cl.: G01R 31/02

(54) **VERFAHREN UND VORRICHTUNG ZUR POLARITÄTSPRÜFUNG VON ELEKTROLYTKONDENSATOREN**
POLARITY TESTING PROCESS AND DEVICE FOR ELECTROLYTIC CAPACITORS
PROCEDE ET DISPOSITIF POUR LES TESTS DE POLARITE DE CONDENSATEURS ELECTROLYTIQUES

(30) Priorität: 16.11.1991 DE 4137758
(43) Veröffentlichungstag der Anmeldung: 31.08.1994
(73) Patentinhaber: ROBERT BOSCH GMBH, D-70442 Stuttgart (DE)
(72) Erfinder: BUNDSCHUH, Goetz, D-7016 Gerlingen (DE); STERZL, Axel, D-7410 Reutlingen (DE)
(86) Internationale Anmeldenummer: DE9200923
(87) Internationale Veröffentlichungsnummer: WO9310464

(56) Entgegenhaltungen:
- EP-A- 0 185 255
- EP-A- 0 258 516
- DE-A- 3 213 110
- PATENT ABSTRACTS OF JAPAN vol. 15, no. 166 (P-1195)25. April 1991

## Beschreibung

### Stand der Technik

Die Erfindung betrifft ein Verfahren und eine Vorrichtung zur Polaritätsprüfung von nassen Aluminium-Elektrolytkondensatoren mit metallischem Gehäuse und wenigstens zwei Anschlüssen unterschiedlicher Polarität.

Die Erkennung verpolt eingesetzter Aluminium-Elektrolytkondensatoren, im folgenden kurz als Elkos bezeichnet, bei der elektrischen Endkontrolle ist oft kaum, wenn überhaupt, möglich. Dies kann zu Feldausfällen von Elkos durch Verpolung führen. Um dies zu verhindern, wurden bereits optische und mechanische Polaritätskennzeichnungen an Elkos verwendet, um entweder durch unterschiedliche Anschlußdrähte die Polarität zu erkennen oder ein Einsetzen in eine Platine nur in der korrekten Weise möglich zu machen. Hierzu wurden unterschiedliche Anschlußdrähte verwendet, die sich durch Unterschiede in der Quetschung, Biegung, Dicke, Farbe od.dgl. unterscheiden. Diese optischen und mechanischen Polaritätskennzeichnungen erfordern jedoch zusätzliche Fertigungsschritte am Elko, die nicht nur die Zuverlässigkeit beeinträchtigen können, sondern auch die Kosten erhöhen. Während optische Polaritätskennzeichnungen oft unzuverlässig und nach dem Einlöten in einer Platine oft schlecht erkennbar sind, erfordern die mechanischen Polaritätskennzeichnungen in aufwendiger Weise noch zusätzliche Maßnahmen an den Platinen, z. B. unterschiedlich große Bohrungen oder unterschiedlich geformte Durchbrüche, deren Anbringung aufwendig und teuer ist.

Aus der DE 32 13 110 A1 ist bereits ein Verfahren und eine Vorrichtung zur Polaritätsprüfung von Elektrolytkondensatoren bekannt, bei dem die einzelnen Kondensatorplatten gegenüber einer Hilfskondensatorplatte aufgeladen werden. Es werden dann die Spannungen ausgewertet, die an den Kondensatorplatten des zu prüfenden Kodensators anliegen. Aus der EP 185 255 A1 ist bereits ein Verfahren und eine Vorrichtung zur Polaritätsprüfung von Elektrolytkondensatoren bekannt, bei dem die Ströme durch die Anschlüsse des Kondensators jeweils gleich sind. Es werden dann jeweils die Kapazitäten gegenüber einer Sonde ausgewertet.

### Vorteile der Erfindung

Das erfindungsgemäße Verfahren mit den kennzeichnenden Merkmalen des Hauptanspruchs und die erfindungsgemäße Vorrichtung mit den kennzeichnenden Merkmalen des Anspruchs 3 haben den Vorteil, daß eine Polaritätserkennung bei allen Elkos unabhängig von ihrer Bauform und der Beschaffenheit der Anschlüsse möglich ist, also beispielsweise sowohl bei radialen als auch bei axialen Elkos, wobei diese Elkos lediglich ein Metallgehäuse besitzen müssen. Die erfindungsgemäße Polaritätserkennung ist also bei nahezu allen auf dem Markt erhältlichen Elkos möglich. Aus diesem Grunde sind keine Sonderausführungen der Elkos und keine Layout-Variationen an den Platinen erforderlich, was zu einer Verringerung von Kosten und Fertigungsschritten führt. Die Prüfung ist am Einzelbauelement wie auch an der fertigen Schaltung möglich, das heißt, es kann auch eine Endprüfung durchgeführt werden. In der Schaltung parallel zum zu prüfenden Elko liegende Widerstände, Kondensatoren, Dioden, Transistoren und ICs beeinträchtigen das Ergebnis nicht, sofern die parallel zum Elko liegende Impedanz unter 10 Ohm (bei gegebener Meßfrequenz f = 50 Hz) liegt. Durch die Möglichkeit der Verwendung von kleinen Meßspannungen werden mit dem Elko verbundene andere Bauelemente nicht beschädigt oder zerstört. Eine Vorrichtung zur Polaritätserkennung kann einfach und kostengünstig realisiert werden, wobei sehr kurze Meßzeiten von etwa 60 ms möglich sind.

Durch die in den Unteransprüchen aufgeführten Maßnahmen sind vorteilhafte Weiterbildungen und Verbesserungen des im Anspruch 1 angegebenen Verfahrens und der im Anspruch 3 angegebenen Vorrichtung möglich.

Die Meßwiderstände sind zweckmäßigerweise mit an die Polanschlüsse des Kondensators anlegbaren Prüfleitungen verbunden, die aus einer Kathodenleitung und einer Anodenleitung bestehen, wobei durch die Anzeigemittel bei korrektem Anschluß der Prüfleitungen ein entsprechendes Anzeigesignal auslösbar ist. Hierdurch ist ein schnelles und einfaches Prüfen möglich, wobei durch die Kennzeichnung der Prüfleitungen die entsprechende Zuordnung zu den Polanschlüssen des Kondensators herstellbar ist.

Das Meßprinzip beruht in vorteilhafter Weise darauf, daß die Auswerteschaltung Mittel zum Vergleich der Amplitude und/oder Phasenlage der Spannungen an den beiden Meßwiderständen aufweist, wobei der mit dem Kathodenanschluß (Minusanschluß) des Kondensators verbundene Meßwiderstand eine bei gleich großen Meßwiderständen höhere und/oder nacheilende Spannung gegenüber der Anoden-Spannung (oder Spannung, die über eine entsprechend geschalteten Meßwiderstand abfällt) aufweist.

Eine vorteilhafte schaltungsmäßige Ausgestaltung der Auswerteschaltung besteht darin, daß sie Mittel zur Bildung einer ersten Rechteckspannung aufweist, die aus der am mit dem Kathodenanschluß oder Anodenanschluß (je nachdem, ob der Kondensator richtig gepolt oder verpolt ist) des Kondensators verbundenen Meßwiderstand abgegriffenen Spannung abgeleitet ist, und Mittel zur Bildung einer zweiten Rechteckspannung aufweist, die aus der Differenz der beiden an den beiden Meßwiderständen abgegriffenen Spannungen abgeleitet ist, und daß Prüfmittel zur Prüfung des gleichzeitigen Auftretens der zweiten Rechteckspannung und des Signalendbereichs der ersten Rechteckspannung vorgesehen sind, wobei das Anzeigesignal in Abhängigkeit des Prüfergebnisses durch die Prüfmittel auslösbar ist. Die Anzeige der korrekten oder nicht korrekten Polarität erfolgt dadurch schnell, sicher und automatisch, da auch bei kleinen Differenzen der Amplitude und der Phasenlage eine eindeutige Polaritätserkennung möglich ist.

Zur Erhöhung der Meßsicherheit weist die Auswerteschaltung Mittel zur Prüfung des Vorliegens von korrekten Meßsignalen auf, durch die bei nicht korrekten Meßsignalen das Anzeigesignal sperrbar und/oder ein Warnsignal auslösbar ist. Liegt beispielsweise eine Prüfspitze zur Zuführung der Meßwechsel-spannung zum Gehäuse des Kondensators nicht korrekt an, so wird infolge des Ausbleibens der Meßsignale ein Fehlersignal erzeugt, das ein etwa vorliegendes Anzeigesignal, das eine korrekte Polarität meldet, ungültig macht.

Die Prüfwechselspannung wird einfach und kostengünstig aus der Netzwechselspannung abgeleitet, so daß eine Prüffrequenz von 50 Hz vorliegt. Um einen zuverlässigen Schutz umgebender und angeschlossener anderer Bauelemente auf einer Platine zu erreichen, wählt man für die Meßspannung zweckmäßigerweise einen Wert von weniger als 0,5 V, vorzugsweise einen Wert im Millivoltbereich.

### Zeichnung

Ein Ausführungsbeispiel der Erfindung ist in der Zeichnung dargestellt und in der nachfolgenden Beschreibung näher erläutert. Es zeigen:
- Fig. 1: eine schematische Darstellung einer Vorrichtung zur Polaritätsprüfung von Elektrolytkondensatoren als Ausführungsbeispiel der Erfindung,
- Fig. 2: ein Ersatzschaltbild eines Elektrolytkondensators in Verbindung mit einer simulierten Schaltung und den beiden in Fig. 1 dargestellten Meßwiderständen zur Erläuterung des Meßprinzips,
- Fig. 3: ein Blockschaltbild der in Fig. 1 dargestellten Auswerteschaltung und
- Fig. 4: ein Signaldiagramm zur Erläuterung der Wirkungsweise der in Fig. 3 dargestellten Auswerteschaltung.

### Beschreibung des Ausführungsbeispiels

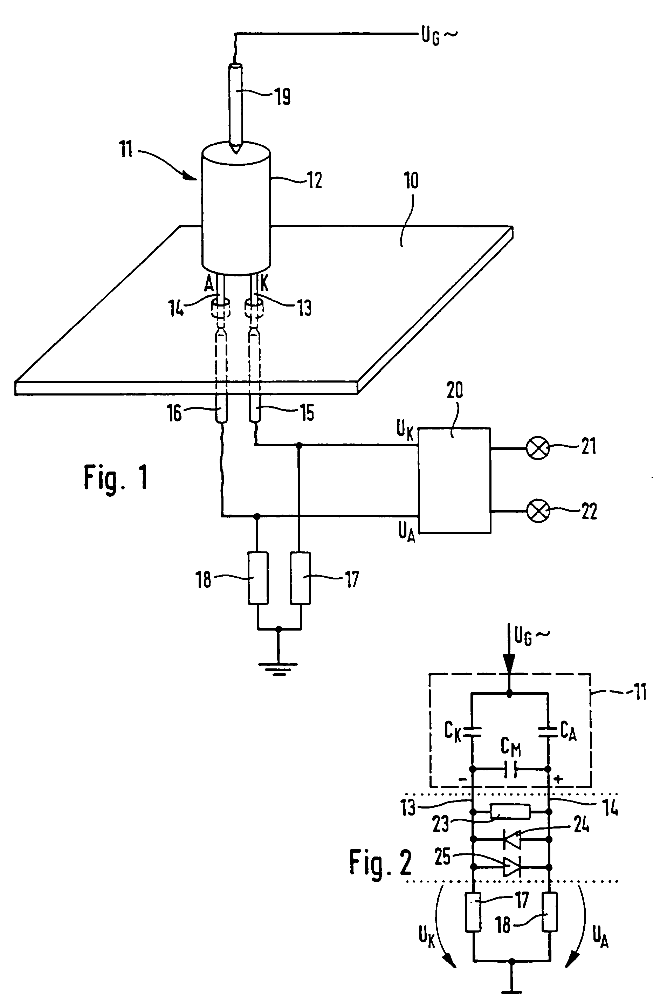

Bei der in Fig. 1 dargestellten Meßanordnung ist eine Platine 10 dargestellt, auf der ein Aluminium-Elektrolytkondensator 11 angebracht ist, dessen Polarität bestimmt bzw. überprüft werden soll. Dieser Elektrolytkondensator 11 wird im folgenden zur Vereinfachung als Elko 11 bezeichnet. Sonstige elektronische Bauelemente, die zusammen mit dem Elko 11 eine elektronische Schaltung bilden, sind zur Vereinfachung nicht auf der Platine 10 dargestellt. Um die erfindungsgemäße Polaritäts erkennung durchführen zu können, muß der Elko 11 ein Metallgehäuse 12 aufweisen, das beim dargestellten Ausführungsbeispiel becherförmig ausgebildet ist. Zwei Polanschlüsse 13,14 des Elkos 11 bilden dessen Kathode K und Anode A. Über zwei Prüfspitzen 15,16 sind die Polanschlüsse 13,14 des Elkos 11 mit zwei Meßwiderständen 17,18 verbunden, die mit ihrem jeweils anderen Anschluß an Masse liegen. Eine Prüfwechselspannung U_{G}, die eine Frequenz von 50 Hz und eine Spannung von 10 Volt aufweist, wird zwischen das Metallgehäuse 12 des Elkos 11 und Masse gelegt. Hierzu dient eine weitere Prüfspitze 19. Der Spannungsabfall U_{K} bzw. U_{A} an den beiden Meßwiderständen 17 bzw. 18 wird einer Auswerteschaltung 20 zugeführt, die ausgangsseitig zwei Prüflampen 21,22 aufweist. Die Spannung U_{K} am Meßwiderstand 17 ist selbstverständlich nur bei korrekt gepoltem Elko 11 die Kathodenspannung. Entsprechendes gilt für die Spannung U_{A} am Meßwiderstand 18, die nur bei korrekt gepoltem Elko 11 die Anodenspannung ist. Zur Prüfung der korrekten Polarität werden die Prüfspitzen 15,16 in der dargestellten Weise an die Polanschlüsse 13,14 und die Prüfspitze 19 an das Metallgehäuse 12 gelegt, worauf dann bei korrekter Polarität die Prüflampe 21 aufleuchtet, die beispielsweise als grüne Prüflampe ausgebildet ist. Bei nicht korrekter Polarität, also bei Vertauschung von Anode und Kathode des Elkos 11, erfolgt kein Aufleuchten.

Weiterhin wird durch die Auswerteschaltung 20 gleichzeitig das Vorhandensein korrekter Meßsignale überprüft, wobei beim Vorliegen nicht korrekter Meßsignale die zweite Prüflampe 22 aufleuchtet, die beispielsweise als rote Prüflampe ausgebildet ist. Solche unkorrekten Meßsignale können beispielsweise bei schlechtem Kontakt der Prüfspitzen, bei Wackelkontakten oder fehlerhafter Prüfwechselspannung auftreten. Sind die Meßsignale dagegen korrekt, erfolgt kein Einschalten der Prüflampe 22.

In Abwandlung der dargestellten Meßanordnung können die Prüfspitzen 19 ganz oder teilweise durch Prüfklemmen ersetzt sein. Weiterhin kann die Prüfwechselspannungsquelle in der Auswerteschaltung 20 enthalten sein, was selbstverständlich auch für die Meßwiderstände 17,18 zutrifft. Es liegt dann eine kompakte Auswertevorrichtung in einem Gehäuse vor, aus dem lediglich drei Prüfleitungen mit drei Prüfspitzen bzw. Prüfklemmen herausgehen.

Anstelle von Prüflampen können selbstverständlich auch andere akustische oder optische Signale zur Kennzeichnung der korrekten oder nicht korrekten Polarität und des Vorliegens von korrekten oder nicht korrekten Meßsignalen eingesetzt werden. Anstelle von zwei Prüflampen kann auch nur eine einzige vorgesehen sein, die beispielsweise beim Vorliegen nicht korrekter Meßsignale blinkt.

Zur Erläuterung der Wirkungsweise der in Fig. 1 dargestellten Vorrichtung soll auf das in Fig. 2 dargestellte Ersatzschaltbild des Elkos 11 eingegangen werden. Neben der Kapazität C_{M} des Elkos zwischen Kathode und Anode sind Kapazitäten zwischen Gehäuse und Kathode sowie zwischen Gehäuse und Anode mit C_{A} bzw. C_{K} bezeichnet. Zur Vereinfachung wurden die Ersatzwiderstände und -induktivitäten vernachlässigt. Weiterhin wurde bei dieser Ersatzschaltung auf die zwischen Elektrolyt und Gehäuse liegende RLC-Kombination verzichtet. Die Anode besitzt eine dicke Oxidschicht, die durch den Formatierprozeß aufgebaut wurde, während die Kathode eine dünne Oxidschicht (Luftoxidation) aufweist. Daher ist C_{K}>>C_{A}. Messungen an verschiedenen Elkos haben ergeben, daß C_{K} und C_{A} von der Gehäuseabmessung und demzufolge von der Nennkapazität und Nennspannung abhängen. Dabei ist C_{K} immer größer als C_{A}.

Um eine Schaltung mit aktiven und passiven Bauelementen zu simulieren, sind ein Widerstand 23 mit 10 0hm und zwei Dioden 24,25 antiparallel zwischen die Polanschlüsse 13,14, also zwischen Anode und Kathode des Elkos 11, geschaltet.

Infolge der unterschiedlichen Kapazitäten C_{K} und C_{A} fließen infolge der angelegten Prüfwechselspannung U_{G} unterschiedliche Ströme durch die Meßwiderstände 17,18, so daß unterschiedliche Meßspannungen U_{K} und U_{A} an diesen Meßwiderständen abgegriffen werden können. Diese unterscheiden sich sowohl in Phase als auch in Amplitude. Je nach Aufbau des Elkos 11 überwiegt bei der Auswertung dieser Spannungen entweder der Amplitudenunterschied oder die Phasenverschiebung. Es ist folgende Tendenz festzustellen: Je größer C_{A} und C_{K}, also die Gehäusegröße, desto größer wird die Phasenverschiebung, und der relative Amplitudenunterschied verringert sich. In jedem Falle ist jedoch die Amplitude von U_{K} größer als die von U_{A}, und U_{K} ist hinsichtlich der Phasenlage gegenüber U_{A} nacheilend. Dieser Sachverhalt wird in der Auswerteschaltung 20 elektrisch ausgewertet und zur Bestimmung der Polung benutzt.

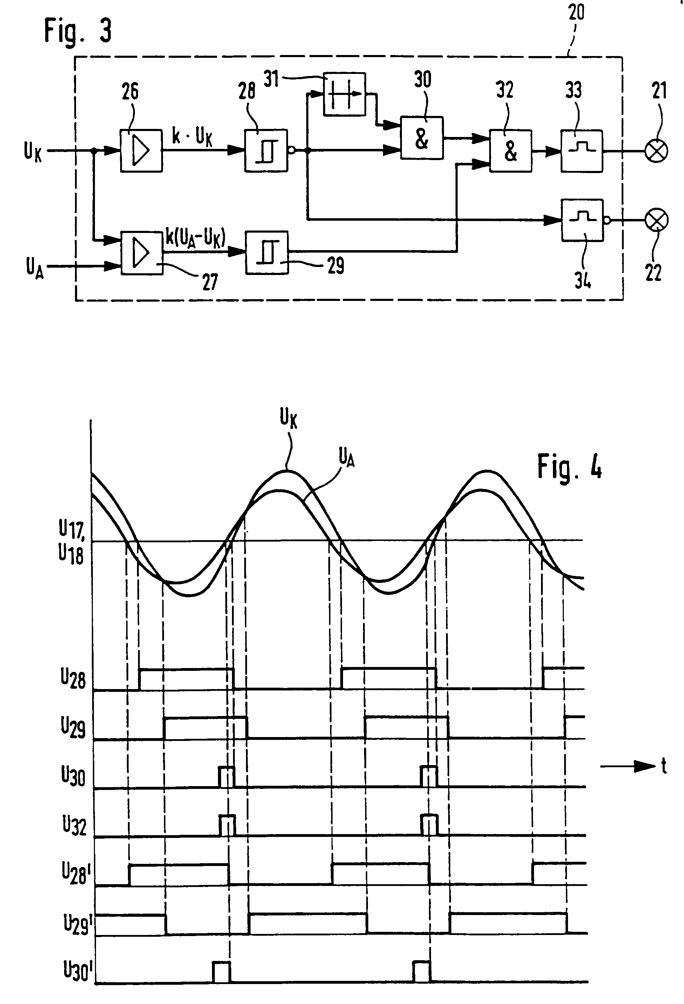

In Fig. 3 ist eine beispielhafte Ausführungsform der in Fig. 1 dargestellten Auswerteschaltung 20 als Blockschaltbild dargestellt. Die dort eingetragenen Spannungen gelten für den korrekt gepolten Elko 11. Die am Meßwiderstand 17 abgegriffene Spannung U_{K} wird dabei einem ersten Verstärker 26 mit dem Verstärkungsfaktor k zugeführt. Weiterhin werden beide Meßspannungen U_{K} und U_{A} einem zweiten, als Differenzverstärker ausgebildeten Verstärker 27 zugeführt, der ebenfalls den erstärkungsfaktor k aufweist. Die Ausgänge der Verstärker 26,27 sind mit Eingängen von Signalformerstufen 28,29 verbunden, durch die die sinusförmigen Eingangsspannungen in Rechteckspannungen umgewandelt werden. Bei diesen Signalformerstufen kann es sich beispielsweise um Schmitt-Trigger handeln. Die Signalformerstufe 28 weist dabei einen invertierenden Ausgang auf, der mit einem Eingang eines UND-Gatters 30 und über ein Zeitverzögerungsglied 31 mit dem zweiten Eingang des UND-Gatters 30 verbunden ist. Dessen Ausgang ist mit einem Eingang eines zweiten UND-Gatters 32 verbunden, dessen zweiter Eingang mit Ausgangssignalen der Signalformerstufe 29 versorgt wird. Das UND-Gatter 30 steuert über ein retriggerbares Zeitglied 33 die Prüflampe 21, während der invertierende Ausgang der Signalformerstufe 28 über ein weiteres retriggerbares Zeitglied 34 mit invertierendem Ausgang die Prüflampe 22 steuert.

Die Wirkungsweise der in Fig. 4 dargestellten Auswerteschaltung 20 wird im folgenden anhand des in Fig. 4 dargestellten Signaldiagramms erläutert. Die verschiedenen Signale sind zur Zuordnung mit Ziffern versehen, die dasjenige Bauteil bezeichnen, dessen Ausgangssignale sie darstellen.

Zunächst wird davon ausgegangen, daß die Prüfspitzen 15,16 in korrekter Weise an die Kathode und Anode des Elkos 11 angelegt sind. Im Differenzverstärker 27 wird das Signal k (U_{A} - U_{K}), also das Differenzsignal zwischen den beiden Meßspannungen, gebildet. Das invertierte Ausgangssignal der Signalformerstufe 28 wird in der Signalverzögerungsstufe 31 um eine Zeitspanne verzögert, die beinahe der Signaldauer des Signals U₂₈ entspricht. Dadurch wird am Ausgangssignal des UND-Gatters 30 das Signal U₃₀ gebildet, das dem Signal-endbereich des Signals U₂₈ entspricht. Bei korrekter Polung muß dieses Signal U₃₀ infolge der Phasenverschiebung während der Signaldauer eines Signals U₂₉ auftreten, welches dem Differenzsignal U_{A} - U_{K} entspricht. Bei korrekter Polung werden daher am Ausgangssignal des UND-Gatters 32 Signale U₃₂ erzeugt, die den Signalen U₃₀ entsprechen. Diese Signale U₃₂ triggern das retriggerbare Zeitglied 33, so daß die Prüflampe 21 brennt und eine korrekte Polung anzeigt.

In den drei untersten Signalzeilen ist der Fall einer falschen Polung dargestellt, das heißt, die Prüfspitze 15 ist mit der Anode und die Prüfspitze 16 mit der Kathode des Elkos 11 verbunden. Demzufolge ergibt sich das Signal U_{28'} am Ausgang der Signalformerstufe 28 jetzt aus dem Meßsignal U_{A}. Entsprechend ergibt sich das Signal U_{29'} aus dem Differenzsignal U_{K} - U_{A}. In diesem Falle tritt das Signal U_{30'} nicht gleichzeitig mit einem Signal U_{29'} auf, so daß am Ausgang des UND-Gatters 32 keine Signale auftreten. Das retriggerbare Zeitglied 33 wird nicht getriggert, und die Prüflampe 21 leuchtet nicht.

Zur Erhöhung der Sicherheit wird mittels des retriggerbaren Zeitglieds 34 noch geprüft, ob eine Meßsignalfolge überhaupt anliegt. Beispielsweise bei schlechtem Kontakt einer der Prüfspitzen 15,16,19 können die Meßsignale auch entfallen. In diesem Falle wird das retriggerbare Zeitglied 34 nicht getriggert, so daß die Prüflampe 22 infolge des invertierenden Ausgangs des Zeitglieds 34 leuchtet und fehlerhafte Meßsignale kennzeichnet.

Anstelle der Auswerteschaltung 20 können selbstverständlich auch andere Auswerteschaltungen treten, die in Abhängigkeit der Amplituden- und Phasendifferenz der Signale die korrekte oder inkorrekte Polarität eines Elkos erkennen können. Im einfachsten Falle können beispielsweise lediglich die Amplituden miteinander verglichen werden, wobei das Signal U_{K} eine größere Amplitude aufweist. Hierzu könnten beispielsweise die beiden Signale gleichgerichtet und die Mittelwerte miteinander verglichen werden. Weiterhin können bekannte Phasenvergleichschaltungen eingesetzt werden.

Auch zur Prüfung korrekter Meßsignale können anstelle des retriggerbaren Zeitglieds 34 aufwendigere Schaltungsanordnungen eingesetzt werden, durch die beispielsweise auch die Signalabstände, die Frequenz od.dgl. überprüft werden können.

Bei der vorliegenden Beschreibung wurde davon ausgegangen, daß die Meßwiderstände 17,18 gleiche Widerstandswerte aufweisen. Es ist selbstverständlich prinzipiell auch möglich, daß für spezielle Meßwerterfassungen unterschiedliche Widerstandswerte vorliegen, die bei der Auswertung entsprechend berücksichtigt werden.

Die beschriebene Vorrichtung zur Prüfung des Vorliegens von korrekten Meßsignalen, gemäß Fig. 3 das retriggerbare Zeitglied 34, kann neben der Auslösung eines Warnsignals oder alternativ hierzu die Anzeige für die korrekte Polarität sperren, also gemäß dem Ausführungsbeispiel das Aufleuchten der Prüflampe 21 verhindern. Hierdurch ist nur eine einzige Warneinrichtung bzw. Prüflampe erforderlich. Anstelle einer vollständigen Sperrung kann auch ein blinkender Betrieb ausgelöst werden, der unkorrekte Meßsignale kennzeichnet.

## Patentansprüche

1. Verfahren zur Polaritätsprüfung von Elektrolytkondensatoren bei dem eine Prüfwechselspannung (U_{G}) verwendet wird, dadurch gekennzeichnet, daß die Prüfwechselspannung (U_{G}) zwischen ein metallisches Gehäuse (12) und die zwei Anschlüsse (13, 14) des Kondensators (11) gelegt wird und daß die unterschiedlichen, durch diese beiden Anschlüsse (13, 14) fließenden Ströme erfaßt werden, wobei der einen größeren Stromfluß und/oder nacheilenden Stromverlauf gegenüber dem anderen aufweisende Anschluß (13) der Kathodenanschluß ist.

2. Verfahren nach Anspruch 1, dadurch gekennzeichnet, daß die durch die Anschlüsse (13,14) fließenden Ströme als Meßspannungen an in Reihe liegenden Meßwiderständen (17,18) abgegriffen werden.

3. Vorrichtung zur Polaritätsprüfung von Elektrolytkondensatoren mit einer Prüfungspannungsquelle (U_{G}), dadurch gekennzeichnet, daß zwei mit zwei Polanschlüssen (13, 14) des Kondensators (11) verbindbare Meßwiderstände (17, 18) vorgesehen sind, daß die Prüfwechselspannungsquelle (U_{G}) einen mit dem metallischen Gehäuse (12) verbindbaren ersten Spannungsanschluß (19) sowie einen mit den nicht am Kondensator (11) liegenden Anschlüssen der Meßwiderstände (17, 18) verbundenen zweiten Spannungsanschluß aufweist und daß eine jeweils den Spannungsabfall als Meßspannungen (U_{K} und U_{A}) an den beiden Meßwiderständen (17, 18) vergleichende Auswerteschaltung (20) mit diesen verbunden ist, wobei die Auswerteschaltung (20) mit die vorliegende Polarität in Abhängigkeit des Vergleichsergebnisses bewertenden Anzeigemitteln (21) versehen ist.

4. Vorrichtung nach Anspruch 3, dadurch gekennzeichnet, daß die Meßwiderstände (17,18) mit an die Polanschlüsse (13,14) des Kondensators (11) anlegbaren Prüfleitungen (15,16) verbunden sind, die aus einer Kathodenleitung (15) und einer Anodenleitung (16) bestehen, wobei durch die Anzeigemittel (21) bei korrektem Anschluß der Prüfleitungen (15,16) ein entsprechendes Anzeigesignal auslösbar ist.

5. Vorrichtung nach Anspruch 3 oder 4, dadurch gekennzeichnet, daß die Auswerteschaltung (20) Mittel zum Vergleich der Amplitude und/oder Phasenlage der Meßspannungen (U_{K} und U_{A}) an den beiden Meßwiderständen (17,18) aufweist, wobei der mit dem Kathodenanschluß (13) des Kondensators (11) verbundene Meßwiderstand (17) eine bei gleich großen Meßwiderständen (17,18) höhere und/oder nacheilende Spannung gegenüber der anderen aufweist.

6. Vorrichtung nach Anspruch 5, dadurch gekennzeichnet, daß die Auswerteschaltung (20) Mittel (26,28) zur Bildung einer ersten Rechteckspannung (U₂₈) aufweist, die aus der an einem der Meßwiderstände (17) abgegriffenen Spannung (U_{K} bzw. U_{A} bei Verpolung) abgeleitet ist, und Mittel (27,29) zur Bildung einer zweiten Rechteckspannung (U₂₉) aufweist, die aus der Differenz (U_{A} - U_{K} bzw. U_{K} - U_{A} bei Verpolung) der beiden an den beiden Meßwiderständen (17,18) abgegriffenen Spannungen abgeleitet ist, und daß Prüfmittel (31-33) zur Prüfung des gleichzeitigen Auftretens der zweiten Rechteckspannung (U₂₉) und des Signalendbereichs der ersten Rechteckspannung (U₂₈) vorgesehen sind, wobei das Anzeigesignal in Abhängigkeit des Prüfergebnisses durch die Prüfmittel (31-33) auslösbar ist.

7. Vorrichtung nach einem der Ansprüche 3 bis 6. dadurch gekennzeichnet, daß die Auswerteschaltung (20) Mittel (34) zur Prüfung des Vorliegens von korrekten Meßsignalen aufweist, durch die bei nicht korrekten Meßsignalen das Anzeigesignal sperrbar und/oder ein Warnsignal auslösbar ist.

8. Vorrichtung nach einem der Ansprüche 3 bis 7, dadurch gekennzeichnet, daß zur Verbindung der Meßwechselspannungsquelle (U_{G}) mit dem Gehäuse (12) des Kondensators (11) eine Signalleitung und/oder eine Prüfspitze (19) vorgesehen ist.

9. Vorrichtung nach einem der vorhergehenden Ansprüche, dadurch gekennzeichnet, daß die Prüfwechselspannung (U_{G}) die Netzfrequenz aufweist.

10. Vorrichtung nach einem der vorhergehenden Ansprüche, dadurch gekennzeichnet, daß die Meßspannung (U_{K}, U_{A}) kleiner als 0,5 Volt ist.

11. Vorrichtung nach Anspruch 10, dadurch gekennzeichnet, daß die Meßspannung (U_{K}, U_{A}) im Millivoltbereich liegt.

## Claims

1. Method for testing the polarity of electrolytic capacitors, in which an alternating test voltage (U_{G}) is used, characterized in that the alternating test voltage (U_{G}) is applied between a metal housing (12) and the two terminals (13, 14) of the capacitor (11), and in that the different currents flowing through these two terminals (13, 14) are recorded, the terminal (13) having a higher conduction and/or lagging current flow in relation to the other is the cathode terminal.

2. Method according to Claim 1, characterized in that the currents flowing through the terminals (13, 14) are tapped as measuring voltages at measuring resistors (17, 18) connected in series.

3. Device for testing the polarity of electrolytic capacitors, with a test-voltage source (U_{G}), characterized in that two measuring resistors (17, 18) connectable to two pole terminals (13, 14) of the capacitor (11) are provided, in that the alternating test-voltage source (U_{G}) has a first voltage terminal (19) connectable to the metal housing (12) and a second voltage terminal connected to those terminals of the measuring resistors (17, 18) not located on the capacitor (11) and in that an evaluation circuit (20) comparing the voltage drop in each case as measuring voltages (U_{K} and U_{A}) at the two measuring resistors (17, 18) is connected to these, the evaluation circuit (20) being provided with indicator means (21) evaluating the existing polarity as a function of the comparison result.

4. Device according to Claim 3, characterized in that the measuring resistors (17, 18) are connected to test leads (15, 16) which can be applied to the pole terminals (13, 14) of the capacitor (11) and which consist of a cathode lead (15) and of an anode lead (16), an appropriate indication signal being triggerable by the indicator means (21) when the test leads (15, 16) are correctly connected.

5. Device according to Claim 3 or 4, characterized in that the evaluation circuit (20) has means for comparing the amplitude and/or the phase relationship of the measuring voltages (U_{K} and U_{A}) at the two measuring resistors (17, 18), the measuring resistor (17) connected to the cathode terminal (13) of the capacitor (11) having, in relation to the other, a voltage which is higher and/or lagging when the measuring resistors (17, 18) are of the same size.

6. Device according to Claim 5, characterized in that the evaluation circuit (20) has means (26, 28) for forming a first square-wave voltage (U₂₈) Which is derived from the voltage (U_{K} or U_{A} in the case of pole reversal) tapped at one of the measuring resistors (17), and means (27, 29) for forming a second square-wave voltage (U₂₉) which is derived from the difference (U_{A} - U_{K} or U_{K} - U_{A} in the case of pole reversal) between the two voltages tapped at the two measuring resistors (17, 18), and in that test means (31-33) are provided for testing the simultaneous occurrence of the second square-wave voltage (U₂₉) and of the signal end region of the first square-wave voltage (U₂₈), the indication signal being triggerable by the test means (31-33) as a function of the test result.

7. Device according to one of Claims 3 to 6, characterized in that the evaluation circuit (20) has means (34) for testing the presence of correct measuring signals, by which means, when the measuring signals are incorrect, the indication signal can be blocked and/or a warning signal can be triggered.

8. Device according to one of Claims 3 to 7, characterized in that a signal lead and/or a probe tip (19) is provided for connecting the alternating measuring-voltage source (U_{G}) to the housing (12) of the capacitor (11).

9. Device according to one of the preceding claims, characterized in that the alternating test voltage (U_{G}) has mains frequency.

10. Device according to one of the preceding claims, characterized in that the measuring voltage (U_{K}, U_{A}) is lower than 0.5 volt.

11. Device according to Claim 10, characterized in that the measuring voltage (U_{K}, U_{A}) is in the millivolt range.

## Revendications

1. Procédé de contrôle de la polarité de condensateurs à électrolyte, selon lequel on utilise une tension alternative de contrôle (U_{G}), caractérisé en ce que la tension alternative de contrôle (U_{G}) est appliquée entre le boîtier métallique (12) et les deux bornes (13, 14) du condensateur (11) et on détecte les courants traversant les deux bornes (13, 14) et la borne (13) qui correspond à l'intensité la plus grande et/ou à la courbe d'intensité en retard par rapport à l'autre et la cathode.

2. Procédé selon la revendication 1, caractérisé en ce que les courants qui traversent les bornes (13, 14) sont des tensions de mesure prises aux bornes de résistances (17, 18) montées en série.

3. Dispositif de contrôle de polarité de condensateurs à électrolyte, comprenant une source de tension de contrôle (U_{G}), caractérisé par deux résistances de mesure (17,18) reliées aux deux bornes polaires (13, 14) du condensateur (11), la source de tension alternative de contrôle (U_{G}) comportant une première borne de tension (19) qui peut se relier au boîtier métallique (12) ainsi qu'une seconde borne de tension qui se relie aux bornes des résistances de mesure (17,18) non reliées au condensateur (11), et en ce qu'un circuit d'exploitation (20) qui compare chaque fois la chute de tension sous la forme de tensions de mesure (U_{K} et U_{A}) aux bornes des deux résistances (17,18) est relié à cette seconde borne de tension, le circuit d'exploitation (20) étant muni de moyens d'affichage (21) pour la polarité existant en fonction du résultat de la comparaison.

4. Dispositif selon la revendication 3, caractérisé en ce que les résistances de mesure (17, 18) sont reliées à des lignes de contrôle (15, 16) susceptibles d'être appliquées aux bornes (13, 14) du condensateur (11), ces lignes se composant d'une ligne cathodique (15) et d'une ligne anodique (16), et en cas de branchement correct des lignes de contrôle (15, 16), le moyen d'affichage (21) déclenche un signal d'affichage correspondant.

5. Dispositif selon les revendications 3 ou 4, caractérisé en ce que le circuit d'exploitation (20) comporte des moyens pour comparer l'amplitude et/ou la phase des tensions de mesure (U_{K} et U_{A}) sur les deux résistances de mesure (17, 18), la résistance de mesure (17) reliée à la cathode (13) du condensateur (11) ayant une valeur plus élevée et/ou une tension en retard par rapport à l'autre pour des résistances de mesure (17, 18) de même valeur.

6. Dispositif selon la revendication 5, caractérisé en ce que le circuit d'exploitation (20) comporte des moyens (26, 28) pour former une première tension rectangulaire (U₂₈) déduite de la tension (U_{K} ou U_{A}) en cas d'inversion de polarité sur l'une des résistances de mesure (17) et les moyens (27, 29) pour former une seconde tension rectangulaire (U₂₉) déduite de la différence (U_{A} - U_{K} ou U_{K} - U_{A}) en cas d'inversion de polarité des deux tensions prises sur les deux résistances de mesure (17, 18) et des moyens de contrôle (31, 33) pour contrôler l'arrivée simultanée de la seconde tension rectangulaire (U₂₉) et de la plage finale du signal de la première tension rectangulaire (U₂₈), les signaux d'affichage étant déclenchés par les moyens de contrôle (31-33) en fonction du résultat du contrôle.

7. Dispositif selon l'une des revendications 3 à 6, caractérisé en ce que le circuit d'exploitation (20) comprend des moyens (34) pour contrôler la présence de signaux de mesure corrects et qui dans le cas de signaux de mesure erronés, bloquent le signal d'affichage et/ou déclenchent un signal avertisseur.

8. Dispositif selon l'une des revendications 3 à 7, caractérisé en ce que pour relier la source de tension alternative de mesure (U_{G}) au boîtier (12) du condensateur (11), il est prévu une ligne de signal et/ou une pointe de contrôle (19).

9. Dispositif selon l'une des revendications précédentes, caractérisé en ce que la tension alternative de contrôle (U_{G}) est à la fréquence du réseau.

10. Dispositif selon l'une des revendications précédentes, caractérisé en ce que la tension de mesure (U_{K}, U_{A}) est inférieure à 0,5 volt.

11. Dispositif selon la revendication 10, caractérisé en ce que la tension de mesure (U_{K}, U_{A}) est dans le domaine des millivolts.
